Europäisches Patentamt

European Patent Office

Office européen des brevets

(19)

(11) **EP 0 752 591 B1**

(12) **FASCICULE DE BREVET EUROPEEN**

(45) Date de publication et mention
de la délivrance du brevet:
**03.09.2003 Bulletin 2003/36**

(51) Int Cl.7: **G01R 19/25**

(21) Numéro de dépôt: **96410072.1**

(22) Date de dépôt: **18.06.1996**

(54) **Mesure numérique relative de haute précision d'une tension**

Numerische Hochpräzisionsspannungsmessung

Digital high precision voltage measurement

(84) Etats contractants désignés:
**DE FR GB IT**

(30) Priorité: **21.06.1995 FR 9507674**

(43) Date de publication de la demande:
**08.01.1997 Bulletin 1997/02**

(73) Titulaire: **STMicroelectronics S.A.
92120 Montrouge (FR)**

(72) Inventeur: **Nicolai, Jean
13790 Châteauneuf le Rouge (FR)**

(74) Mandataire: **de Beaumont, Michel
1bis, rue Champollion
38000 Grenoble (FR)**

(56) Documents cités:
**US-A- 4 504 922          US-A- 5 099 209**

## Description

La présente invention concerne un procédé et un dispositif de détermination d'une grandeur correspondant à une tension. Elle concerne des applications dans lesquelles on veut détecter avec précision non pas la valeur absolue d'une tension mais les variations de celle-ci.

De telles mesures relatives d'une tension sont par exemple utiles dans des systèmes dans lesquels on veut détecter la variation d'allure d'une courbe de tension en fonction du temps et dans lesquels le coût du système de mesure constitue une contrainte majeure.

Un premier exemple d'une telle application réside dans des détecteurs infrarouges de présence ou autres détecteurs dans lesquels on cherche à détecter une variation par rapport à une valeur de consigne.

L'invention sera décrite dans le cadre d'une autre application, à savoir des chargeurs de batteries, et plus particulièrement des chargeurs destinés à charger des batteries du type nickel-cadmium (NiCd) ou nickel-hydrures métalliques (NiMH). Dans de tels chargeurs, il est souhaitable, à chaque opération de charge, de charger complètement la batterie mais de ne pas excéder une charge maximum qui nuirait au fonctionnement et à la durée de vie de la batterie. Dans de telles batteries, ce niveau de charge maximum correspond à l'apparition d'un point d'inflexion dans la courbe de variation de tension en fonction du temps. Ce point d'inflexion est détecté en mesurant à intervalles réguliers la tension aux bornes de la batterie pendant la charge et en analysant l'évolution des écarts de tension. Quand on passe d'une zone où les écarts de tension sont progressivement croissants à une zone où les écarts de tension sont progressivement décroissants, on a détecté que l'on avait atteint le point d'inflexion. Pour effectuer cette mesure, deux problèmes se posent. D'une part, les écarts doivent être mesurés avec une grande précision, par exemple de l'ordre du millième, ce qui correspond à une mesure numérique sur 10 bits. D'autre part, on peut souhaiter utiliser un même chargeur de batterie pour charger diverses batteries comprenant des nombres différents de cellules. Par exemple, si l'on veut pouvoir charger des batteries comprenant de 3 à 8 cellules, sachant que la tension d'une cellule varie entre 1 et 1,8 volts, il faut être capable de mesurer les écarts susmentionnés autour d'une tension moyenne pouvant se situer dans une plage de sensiblement 3 à 15 volts.

Un dispositif pour mesurer une tension aux bornes d'une batterie est divulgué dans le brevet US 5 099 209 A. Cette mesure est réalisée en détectant séparément le temps de charge d'un condensateur jusqu'à une deuxième tension de référence, d'une part en y appliquant la tension à mesurer et d'autre part en y appliquant une première tension de référence. Un circuit de calcul déduit à partir de ces deux temps et des tensions de référence la tension à mesurer. Ce dispositif a pour inconvénient de nécessiter des moyens de changement pour sélectionner la tension qui doit être appliquée au condensateur ainsi que deux références de tension.

Le moyen le plus simple pour effectuer ces mesures est d'utiliser un convertisseur analogique/numérique intégré dans un microcontrôleur. Si l'on veut une précision de l'ordre du millième, il faut donc prévoir un convertisseur analogique/numérique d'une précision supérieure ou égale à 10 bits. Or, les microcontrôleurs classiques à faible coût tels que le microcontrôleur ST6 de la société SGS-Thomson Microelectronics (ST) sont couramment associés à des convertisseurs analogique/numérique d'une précision de seulement 8 bits (1/250). Par contre, ces microcontrôleurs disposent d'une horloge haute fréquence, de compteurs et de moyens de calcul pouvant fournir des précisions de l'ordre de 16 bits. Ainsi, la présente invention vise à utiliser un microcontrôleur à faible coût pour une mesure relative de tension en effectuant la mesure à partir de comptage de temps et non pas par conversion directe analogique/numérique.

Pour atteindre cet objet, la présente invention prévoit un procédé de détermination d'une grandeur correspondant à une fonction linéaire d'une tension à détecter, comprenant les étapes consistant à charger un condensateur par la tension à détecter, avec une constante de temps déterminée ; déterminer la durée au bout de laquelle la tension aux bornes du condensateur atteint un seuil prédéterminé ; et calculer l'inverse de ladite durée, qui correspond à la grandeur recherchée.

Selon un mode de réalisation de la présente invention, ce procédé comprend les étapes consistant à effectuer périodiquement les calculs d'inverses et calculer la différence entre deux inverses successifs.

La présente invention prévoit aussi un dispositif de détermination d'une grandeur correspondant à une fonction linéaire d'une tension à détecter, comportant un circuit de charge à constante de temps déterminée d'un condensateur et un microcontrôleur. Le microcontrôleur comprend des moyens de comparaison à un seuil prédéterminé de la tension aux bornes du condensateur ; des moyens de remise à zéro de la tension aux bornes du condensateur ; des moyens de comptage de la durée s'étendant entre un instant de fin de remise à zéro du condensateur et l'instant où il atteint le seuil prédéterminé ; et des moyens de calcul de l'inverse de ladite durée, celle-ci correspondant à la grandeur recherchée.

Selon un mode de réalisation de la présente invention, les moyens de comparaison sont constitués d'un inverseur.

Ces objets, caractéristiques et avantages ainsi que d'autres de la présente invention seront exposés en détail dans la description suivante de modes de réalisation particuliers faite, à titre non-limitatif, en relation avec les figures jointes parmi lesquelles :

la figure 1 représente le schéma d'un circuit selon la présente invention ;

la figure 2 représente l'allure de la courbe de charge d'un condensateur en fonction du temps pour diverses valeurs de la tension appliquée ; et

la figure 3 représente des courbes T/RC et 0,5/T pour diverses valeurs de la tension d'entrée ($V_{in}$).

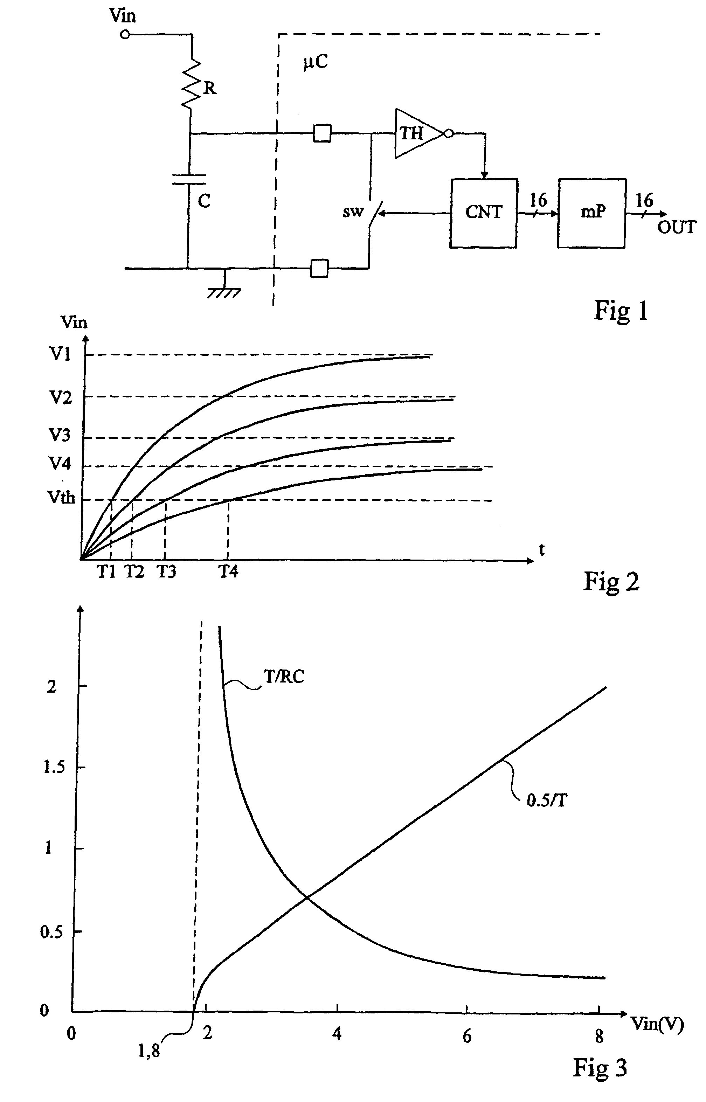

La figure 1 représente un circuit selon la présente invention. Etant donnée une tension à mesurer $V_{in}$, cette tension est appliquée à la connexion en série d'une résistance R et d'un condensateur C. Le point de connexion de la résistance et du condensateur est connecté à l'entrée d'un circuit à seuil TH, par exemple un simple inverseur. La borne du condensateur connectée au potentiel de référence de la tension $V_{in}$, couramment la masse, est reliée à l'entrée du circuit à seuil par l'intermédiaire d'un commutateur SW. Le commutateur SW est commandé par une sortie d'un compteur CNT de façon à être ouvert à intervalles périodiques, pour initialiser un cycle de charge du condensateur C, et à être refermé dès que la tension aux bornes du condensateur C a atteint le seuil $V_{th}$ du circuit TH. La sortie du compteur au moment de la fermeture est transmise à un circuit de mémorisation ou directement à une entrée d'un microprocesseur mP pour traitement. Comme on le verra ci-après, ce traitement consiste essentiellement en un calcul d'inverse et le microprocesseur fournit sur sa sortie OUT une donnée numérique proportionnelle à l'inverse du comptage du compteur. La sortie du compteur CNT et la sortie du microprocesseur mP sont de préférence fournies sur 16 bits. Le microprocesseur pourra également, en relation avec des circuits de mémorisation, mesurer des différences entre valeurs successives de l'inverse des intervalles de temps mesurés par le compteur pour déterminer des écarts de tension entre mesures périodiques.

Comme le représente la figure 1, le circuit selon la présente invention est particulièrement simple, du fait que l'ensemble des composants correspondant au circuit de seuil TH, au commutateur SW, au compteur CNT et au microprocesseur mP sont des composants qui existent dans un microcontrôleur classique à faible coût tel qu'un microcontrôleur ST6. Le circuit selon l'invention ne comprend donc que trois composants, le microcontrôleur, la résistance R et le condensateur C. En fait, dans la plupart des applications visées par la présente invention, le microcontrôleur ne constitue pas un composant spécifique à l'application recherchée puisqu'il est généralement utilisé aussi pour d'autres fonctions. Les seuls éléments matériels nécessaires pour le circuit selon l'invention sont donc la résistance R et le condensateur C.

la figure 2 représente des courbes de tension de charge du condensateur C en fonction du temps pour diverses valeurs V1, V2, V3, V4 de la tension à mesurer $V_{in}$. Ces courbes ont une allure exponentielle et la tension $V_{th}$ sera atteinte en une durée T1, T2, T3, T4 d'autant plus courte que la tension $V_{in}$ est élevée. De

façon connue, cette durée T est définie par l'équation :

$$T/RC = -\ln [1-(V_{th}/V_{in})]$$

Il existe donc une relation logarithmique entre la durée T et la tension à mesurer $V_{in}$. C'est sans doute pourquoi cette mesure n'est généralement pas utilisée.

Toutefois, l'inventeur a tracé des courbes représentant l'inverse de la durée T en fonction de la tension d'entrée $V_{in}$ pour une tension de seuil de 1,8 volts, par exemple, comme le représente la figure 3, la courbe 0,5/T . On s'aperçoit que cette courbe est pratiquement linéaire dès que la tension d'entrée excède 4 volts et que, dans la plage de 2 à 4 volts, cette courbe n'est pas linéaire mais présente une variation continue et faible. Ainsi, les écarts entre valeurs de 1/T sont parfaitement représentatifs des variations de la tension d'entrée $V_{in}$ autour d'une valeur donnée de cette tension.

On notera de plus que, étant donné que selon la présente invention on ne s'intéresse qu'à des valeurs d'écarts, et que l'on ne cherche pas à effectuer une mesure absolue de la tension $V_{in}$, il n'est pas nécessaire de connaître les valeurs exactes de la résistance R, du condensateur C et de la tension de seuil $V_{th}$. Il suffit que, pour un dispositif donné, ces valeurs soient stables dans le temps (et même seulement à l'intérieur d'intervalles de temps relativement brefs).

On ne décrira pas ici les moyens de mise en route du compteur et de programmation du microprocesseur pour effectuer les calculs souhaités, ces calculs étant classiques et particulièrement simples. De plus, étant donné que le microprocesseur a seulement à effectuer des calculs d'inverses de comptages et de différences entre calculs d'inverses successifs, on notera que de tels calculs sont particulièrement simples et peuvent être effectués sans difficulté de façon très rapide.

Si l'on choisit par exemple un compteur à 15 bits (de 1 à 32 768), on choisira les valeurs de la résistance et du condensateur en fonction de la tension de seuil du dispositif à seuil pour que la tension minimale à mesurer (2 volts pour une tension de seuil de 1,8 volts) corresponde sensiblement à un comptage maximum. On obtient ainsi une précision supérieure à un pour mille même dans les plages de tension élevée de l'ordre de 10 à 15 volts pour lesquelles le comptage sera relativement limité, par exemple de l'ordre de 2 800 pour une tension d'entrée de 10 volts dans le cas de l'exemple numérique ci-dessus.

Bien entendu, la présente invention est susceptible de diverses variantes et modifications qui apparaîtront à l'homme de l'art, notamment en ce qui concerne la réalisation des éléments utilisés à l'intérieur du microcontrôleur. En outre, d'autres applications que celle d'un chargeur de batterie pourront être envisagées par l'homme de métier en fonction des problèmes qui lui seront posés.

## Revendications

**1.** Procédé de détermination d'une grandeur correspondant à une fonction linéaire d'une tension à détecter, comprenant les étapes suivantes :

charger un condensateur par la tension à détecter, avec une constante de temps déterminée ;
déterminer la durée au bout de laquelle la tension aux bornes du condensateur atteint un seuil prédéterminé ; et
calculer l'inverse de ladite durée, qui correspond à la grandeur recherchée.

**2.** Procédé selon la revendication 1, **caractérisé en ce qu'**il comprend les étapes suivantes :

effectuer périodiquement les calculs d'inverses ; et
calculer la différence entre deux inverses successifs.

**3.** Dispositif de détermination d'une grandeur correspondant à une fonction linéaire d'une tension à détecter, comprenant un circuit de charge à constante de temps déterminée d'un condensateur (C), le condensateur étant chargeable par la tension à détecter, et un microcontrôleur comprenant :

des moyens (TH) de comparaison à un seuil prédéterminé de la tension aux bornes du condensateur ;
des moyens de remise à zéro de la tension aux bornes du condensateur ;
des moyens (CNT) de comptage de la durée s'étendant entre un instant de fin de remise à zéro du condensateur et l'instant où il atteint le seuil prédéterminé ; et
des moyens (mP) de calcul de l'inverse de ladite durée celle-ci correspondant à la grandeur recherchée.

**4.** Dispositif selon la revendication 3, **caractérisé en ce que** les moyens de comparaison sont constitués d'un inverseur.

## Patentansprüche

**1.** Verfahren zur Bestimmung einer Größe entsprechend einer Linearfunktion einer zu detektierenden Spannung, wobei die folgenden Schritte vorgesehen sind:

Laden eines Kondensators mit der zu detektierenden Spannung mit einer bestimmten Zeitkonstanten;

Bestimmen der Zeitdauer an deren Ende die am Kondensator liegende Spannung eine vorbestimmte Schwelle erreicht; und
Berechnen des der gewünschten bzw. Soll-Größe entsprechenden Reziprokwerts der Zeitdauer.

**2.** Verfahren nach Anspruch 1, **dadurch gekennzeichnet, dass** folgende Schritte vorgesehen sind:

periodische Ausführung der Reziprokwertberechnungen; und
Berechnen der Differenz zwischen zwei aufeinanderfolgenden Reziprokwerten.

**3.** Vorrichtung zur Bestimmung einer Größe entsprechend einer Linearfunktion einer zu detektierenden Spannung, wobei eine Schaltung vorgesehen ist, um einen Kondensator (C) mit einer vorbestimmten Zeitkonstanten zu laden, wobei der Kondensator geeignet ist, um mit der zu detektierenden Spannung geladen zu werden und wobei eine Mikrosteuervorrichtung (microcontroller) Folgendes aufweist:

Mittel (TH) zum Vergleichen der Spannung am Kondensator mit einer vorbestimmten Schwelle;
Mittel zum Zurücksetzen der Spannung am Kondensator;
Mittel (CNT) zum Zählen der Zeitdauer zwischen dem Ende einer Kondensatorrücksetzung und der Zeit wann dieser die vorbestimmte Schwelle erreicht; und
Mittel (mP) zur Berechnung des Reziprokwerts der erwähnten Zeitdauer, die dem gewünschten bzw. Soll-Wert entspricht.

**4.** Vorrichtung nach Anspruch 3, **dadurch gekennzeichnet, dass** die Vergleichsmittel durch einen Inverter gebildet werden.

## Claims

**1.** A method for determining a quantity corresponding to a linear function of a voltage to be detected, including the following steps:

charging a capacitor with the voltage to be detected, with a determined time constant;
determining the duration at the end of which the voltage across the capacitor reaches a predetermined threshold; and
calculating the inverse of said duration, which corresponds to the quantity desired.

**2.** A method according to claim 1, **characterized in that** it includes the following steps:

periodically performing inverse calculations; and

calculating the difference between two successive inverses.

3. A device for determining a quantity corresponding to a linear function of a voltage to be detected, including a circuit for charging with a determined time constant a capacitor (C) the capacitor being adapted to be charged by the voltage to detect, and a microcontroller including:

means (TH) for comparing the voltage across the capacitor with a predetermined threshold;
means for resetting the voltage across the capacitor;
means (CNT) for counting the time duration between the end of a capacitor reset and the time when it reaches the predetermined threshold; and
means (mP) for calculating the inverse of said duration, that correspond to the desired value.

4. A device according to claim 3, **characterized in that** the comparison means are constituted by an inverter.

Fig 1

Fig 2

Fig 3